(19) Europäisches Patentamt

European Patent Office

Office européen des brevets

(11) **EP 0 790 710 B1**

(12) **EUROPEAN PATENT SPECIFICATION**

(45) Date of publication and mention
of the grant of the patent:
**10.05.2000  Bulletin 2000/19**

(51) Int Cl.$^7$: **H03M 13/00**

(21) Application number: **96120815.4**

(22) Date of filing: **23.12.1996**

(54) **Method for rapid validation and coding of cyclic codes**

Verfahren zur raschen Validation und Codierung zyklischer Code

Méthode pour la validation rapide et la codification pour code cyclique

(84) Designated Contracting States:
**DE FR GB SE**

(30) Priority: **22.12.1995  IT   TO951038**

(43) Date of publication of application:
**20.08.1997   Bulletin 1997/34**

(73) Proprietor: **ANSALDO TRASPORTI S.p.A.**
**I-80147 Napoli (IT)**

(72) Inventor: **Tamponi, Aldo**
**16146 Genova (IT)**

(74) Representative: **Jorio, Paolo et al**
**STUDIO TORTA S.r.l.,**
**Via Viotti, 9**
**10121 Torino (IT)**

(56) References cited:
**EP-A- 0 053 505**          **EP-A- 0 154 538**
**US-A- 5 131 012**

## Description

The present invention relates to a method for rapid validation and coding of cyclic codes.

As is known, cyclic codes are a particular class of linear parity check codes, and are of enormous practical use by comprising, not only all the characteristics of parity check codes, but also certain specific characteristics for simplifying decoding using simple mathematical algorithms.

The main characteristic of a cyclic code is the following: a linear code is a cyclic code if, and only if, a cyclic shift of a code word produces another code word. Details of cyclic codes are to be found in numerous publications on transmission theory, such as, "DIGITAL TRANSMISSION THEORY" by S. Benedetto, E. Biglieri and V. Castellani, Prentice-Hall International Editions.

Decoding of a cyclic code is preceded by determining a sequence of n bits defining a received vector $r=(r_0,r_1,......,r_{n-1})$, which, due to noise along the transmission channel, may be other than the transmitted cyclic code. When decoding a cyclic code, therefore, a preliminary or validity check is made to determine acceptability of the received vector, e.g. by examining the so-called syndrome s, which is defined as the product of vector r multiplied by the transpose of a parity check matrix H, i.e. $s=rH^T$. If syndrome s equals a zero vector, vector r is an acceptable code word; whereas, if the syndrome equals other than a zero vector, vector r contains transmission errors or, at any rate, is invalid as a code word. For instance EP-A-154 538 discloses a syndrome generator for the detection and/or the correction of errors in a communication system

The validity check is followed by the actual decoding step (if necessary) using known mathematical algorithms, and, following or concurrently with this, another sequence of n bits defining a further vector r' for decoding is received. Vector r' may comprise part of the bits of the previously received vector r together with other bits received after the last bit of vector r so as to analyze the data in groups of n in an "observation window" moving over the entire received bit sequence.

Since, as stated, any cyclic rotation of a code word of a cyclic code produces another code word, the corresponding syndrome of which is zero, a vector may also be validated by calculating its rotation syndrome as opposed to its syndrome.

As another n-bit syndrome is also calculated for vector r', known validation operations therefore involve calculating a number of syndromes, one for each received vector. This is normally done using a dividing circuit comprising a shift register into which all the bits forming the received vector are entered sequentially. For each received vector, therefore, all the bits forming the vector are entered into the shift register, and, between two successive syndrome calculations, the shift register must be reset, thus making calculation of the syndrome fairly complex and enormously time-consuming. Patent US-A-5,131,012 discloses a method of synchronization of cyclic codes which performs an update of a previous validation.

It is an object of the present invention to provide a method permitting rapid validation of a cyclic code.

In view of the close structural similarity - acknowledged in literature - between validation and coding operations, the method according to the present invention may also be used for accelerating coding of a cyclic code.

According to the present invention, there are provided a method for rapid validation of cyclic codes, as claimed in Claim 1, and a method for rapid coding of cyclic codes, as claimed in Claim 17.

The invention will now be described with reference to the accompanying drawings, in which:

Figure 1 shows a block diagram of the steps in the method according to the present invention, for performing a syndrome-based validity check;

Figure 2 shows a block diagram of the steps in the method according to the present invention, for performing a validity check based on calculation of the parity check bits;

Figure 3 shows a block diagram of the steps in the method according to the present invention, as applied to parity check coding.

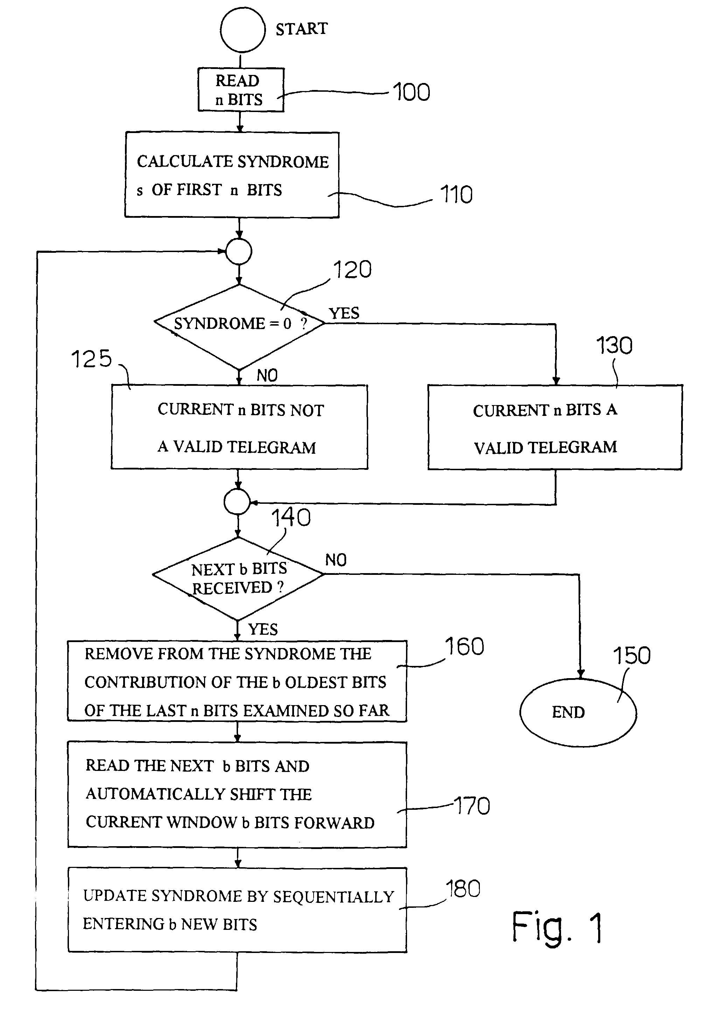

The steps in the method according to the present invention will now be described with reference to Figure 1.

To begin with, a block 100 reads n bits forming part of a bit sequence supplied over a transmission channel (not shown) by a remote transmission source (not shown) transmitting a cyclic code, and which are acquired sequentially and memorized. Purely by way of a non-limiting example, the transmission source may comprise a transmitter (not shown) located along a railway line (not shown) and for cyclically transmitting a bit sequence to a receiver-demodulator (not shown) on a rail vehicle (not shown) on the line.

The n-bit sequence defines a vector $r=(r_0, r_1,......,r_{n-1})$ of length n.

Block 100 is followed by a block 110, which, in known manner, calculates a control function, e.g. the syndrome s function, of the n bits acquired by the previous block 100.

Syndrome 2 may be calculated with reference to vector r, by multiplying vector r by the transpose of a parity check matrix H, i.e. $s=rH^T$ .

More details concerning the syndrome calculation are to be found in "ERROR CORRECTING CODES" by Shu Lin and Daniel Costello, PRENTICE HALL Editions, which also explains how the syndrome is used for correcting errors detected during validation. Syndrome s contains information relative to the presence and location of transmission errors, and is defined by a vector of length n-k, where n is the size of vector r, and k the number of information bits in vector r.

An important point to note is that syndrome s may also be calculated using sequential algorithms, e. g. shift registers (not shown) into which the bits forming the vector for examination are entered sequentially. Examples of shift registers are given in "ERROR CONTROL CODING" by Shu Lin and Daniel Costello, PRENTICE HALL Editions.

Depending on the properties of the cyclic codes, the syndrome function may also be calculated with reference to any cyclic rotation of vector r, by multiplying the cyclic rotation of the received vector r by the transpose of a parity check matrix H. To calculate the syndrome of a rotation of r, as opposed to rotating r, the columns of matrix H are interchanged or changes made to the shift register (not shown) into which r is entered.

In fact, like the syndrome of vector r itself, the syndrome of a cyclic rotation of vector r equals a zero vector if, and only if, vector r is an acceptable code word. Conversely, both syndromes (that of vector r and its rotation) equal other than a zero vector, but may differ from each other. In the following description, however, the s symbol is used for both the syndrome of vector r and that of its rotation.

Block 110 is followed by a block 120, which examines the syndrome s calculated in the previous block 110. If syndrome s equals a zero vector, block 120 goes on to a block 130. Conversely (syndrome s equal to other than a zero vector), block 120 goes on to a block 125.

Block 130 determines that the previously acquired n-bit sequence (telegram) forms a received message acknowledged as forming part of the code. As is known, if syndrome s equals a zero vector, vector r is an acceptable code word, whereas, if syndrome s equals other than a zero vector, the presence of transmission errors in vector r, or at any rate the invalidity of vector r as a code word, is detected (block 125). Both blocks 125 and 130 are followed by block 140.

Block 140 determines whether a sufficient number of bits (e.g. b bits) have been received to permit further processing. If they have not, block 140 goes on to block 150, which terminates the data acquisition and validation operations. If they have, block 140 goes on to block 160.

Block 160 calculates the syndrome (referred to, for the sake of simplicity, as the pseudosyndrome) $s^p$ of a dummy vector $r_b$ of length n, the first b bits of which equal zero, and the next n-b bits of which equal the corresponding bits of vector r, i.e.:

$$s^p = r_b H^T$$

where $r_b = (0, .. .. , 0, r_b, ......, r_{n-1})$

In other words, vector $r_b$ is obtained from vector r by zeroing the first b bits of vector r.

The pseudosyndrome is calculated by "subtracting" from the current syndrome s a correction syndrome calculated for a correction vector $r^* = (r_0, r_1, ......, r_{b-1}, ,0, ....,0)$ of length n, the first b bits of which equal the corresponding bits of vector r, and the next n-b bits of which equal zero. Depending on the properties of the cyclic codes, the correction syndrome may be calculated on the basis of a cyclic rotation of vector $r^* = (r_0, r_1, ......, r_{b-1}, ,0, ....,0)$. More specifically, the correction syndrome is calculated on the basis of a cyclic rotation of vector $r^* = (r_0, r_1, ......, r_{b-1}, ,0, ....,0)$ when the calculation in block 110 is also made on the basis of a rotation of r, and with reference to the same rotation as in block.

The pseudosyndrome calculation is explained by the linearity of the syndrome (the syndrome of the sum equals the sum of the syndromes) so that syndrome s of vector $r = (r_0, r_1, ......, r_{n-1})$ may be thought of as being the sum of the syndromes of correction vector $r^* = (r_0, r_1, ......, r_{b-1}, ,0, ....,0)$ and of dummy vector $r_b = (0, .. .., 0, r_b, ......, r_{n-1})$, i.e.: $(r_0, r_1, ......, r_{n-1}) H^T = (r_0, r_1, ......, r_{b-1}, , 0, ....,0) H^T + (0, .. .., 0, r_b, ......, r_{n-1}) H^T$ so that: $(0, .. .., 0, r_b, ......, r_{n-1}) H^T = (r_0, r_1, ......, r_{n-1}) H^T - (r_0, r_1, ......, r_{b-1}, , 0, ....,0) H^T$ where the - sign indicates an EXOR logic operation. In other words, block 160 calculates pseudosyndrome $s^p$ by performing an EXOR operation of the current syndrome s and the correction syndrome.

In the event b < n - k, where k is the number of information bits of received vector r, a highly simplified form of the correction syndrome may be obtained by referring the entire syndrome calculation procedure to a cyclic rotation of the vector in question, as opposed to the vector itself, so that the first n-k bits of the vector become the last; in which case, the correction syndrome comprises a sequence of bits comprising the first b bits $(r_0, r_1, ......, r_{b-1})$ of received vector r, followed by n-k-b zero bits. The same also applies to lesser rotations of vector r, providing they are no less than b.

Even in the event n - k < b ≤ n, the correction syndrome need not be calculated for each b-bit "advance," by depending, for a given type of cyclic code, solely on the correction sequence as opposed to the current processing status, and may therefore be calculated once for each sequence $(r_0, r_1, ......, r_{b-1}, ,0, ....,0)$, memorized in a table, and used for fast table searches.

Block 160 is followed by a block 170, which reads b bits following the last bit used to calculate the current syndrome.

Block 170 is followed by a block 180, which updates the current syndrome s with the b bits detected in block 170 and as of the current pseudosyndrome $s^p$ value. For example, block 180 sequentially enters the b new bits detected in block 170 into the shift register forming the pseudosyndrome to obtain a new current syndrome.

A new control function value is thus calculated for a new bit sequence (new vector) comprising, in sequence, the last n-b bits of the received vector and the next b new bits, so as to analyze the data in groups of n in an "observation window" moving over the entire sequence of received bits in steps b (where $1 \leq b \leq n$). Finally, block 180 goes back to block 120.

For the sake of simplicity, the s symbol is also used in block 120 to indicate a new syndrome of a new vector r, which is to be taken as indicating the starting point of any update of the syndrome at any shift of the observation window.

The advantages of the method according to the present invention will be clear from the foregoing description. That is, as opposed to calculating a new n-bit syndrome, the operation (syndrome calculation) in block 180 is performed by updating a previously calculated (pseudo) syndrome with b new bits. In other words, as opposed to resetting the shift register and entering n new bits, a new syndrome is calculated by updating the content of the shift register with b new bits (where $b \leq n$). Bearing in mind that one bit is entered into the shift register at each CLOCK pulse, calculation of the syndrome according to the above method is decidedly faster as compared with the corresponding known operation. Moreover, in addition to being extremely fast, the above method is also straightforward and may be applied generally to any type of cyclic redundancy code.

To further accelerate validation according to the method of the present invention, the operations in block 180 may also be performed, by means of software algorithms or appropriate hardware structures, by performing the operations corresponding to each bit, as well as the operations in blocks 160 and 170, concurrently.

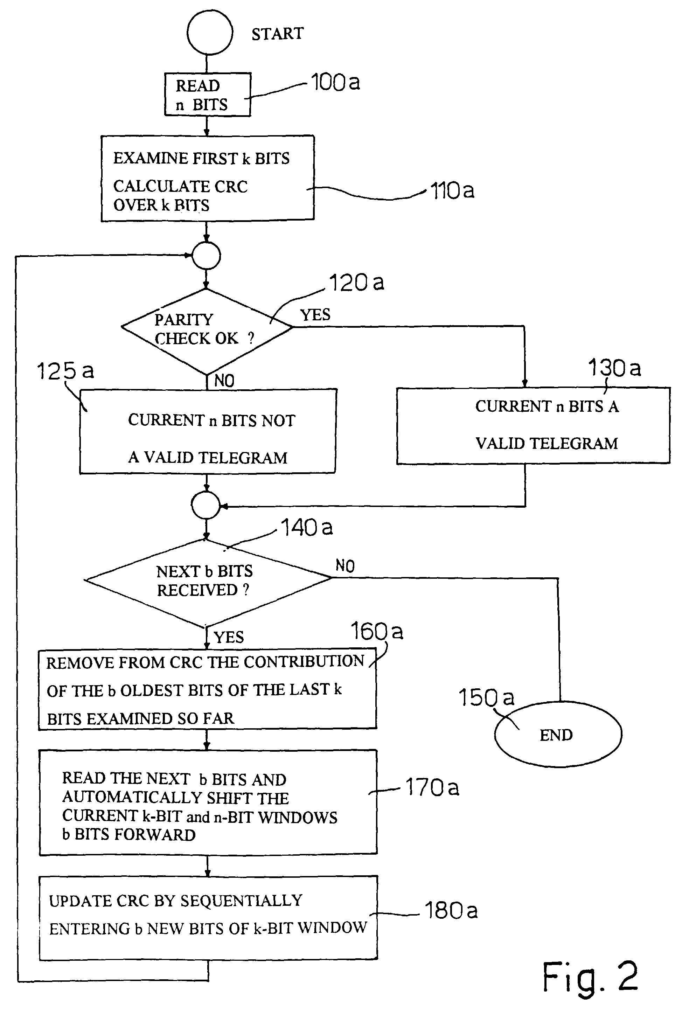

The Figure 2 method differs from that in Figure 1 by the control function being calculated by calculating the parity check bits (so-called CRC calculation) as opposed to the syndrome.

To begin with, a block 100a reads n bits forming part of a bit sequence supplied over a transmission channel (not shown) by a remote transmission source (not shown) transmitting a cyclic code, and which are acquired sequentially and memorized.

The n-bit sequence defines a vector $r=(r_0, r_1,......,r_{n-1})$ of length n.

Block 100a is followed by a block 110a, which examines the first k information bits of received vector r; and the same parity check law as in transmission is applied to the k bits to obtain a bit set (parity or CRC calculation).

More details concerning CRC calculation are to be found in "ERROR CORRECTING CODES" by Shu Lin and Daniel Costello, PRENTICE HALL Editions.

In the next block 120a, the bit set calculated in block 110a is compared with the last n-k bits of the received vector, which should correspond to the parity check bits. If the bit set calculated in block 110a corresponds to the n-k parity check bits, block 120a goes on to block 130a. Conversely, block 120a goes on to block 125a.

Block 130a determines that the previously acquired n-bit sequence (telegram) forms a received message acknowledged as forming part of the code, whereas block 125a determines the presence of transmission errors in vector r, or at any rate the invalidity of vector r as a code word. Both blocks 125a and 130a are followed by block 140a.

Block 140a determines whether a sufficient number of bits (e.g. b bits) have been received to permit further processing. If they have not, block 140a goes on to block 150a, which terminates the data acquisition and validation operations. If they have, block 140a goes on to block 160a.

Block 160a calculates the parity check (CRC$^P$) of a dummy vector $r_b$ of length k, the first b bits of which equal zero, and the next k-b bits of which equal the corresponding bits of vector r, i.e.: $r_b=(0, .. ..,0,r_b,......,r_{k-1})$ The parity check for the dummy vector is calculated by "subtracting" from the current parity check a correction parity check calculated for a correction vector $r^{**}=(r_0, r_1, .. . . ,r_{b-1},0......,0)$ of length k. The subtraction may be made by performing a logic EXOR operation of each bit of the current parity check and the corresponding bit of the correction parity check.

Block 160a is followed by block 170a, which reads b bits following the n bits currently being validated; and the position of the n bits currently being validated - vector r - and the "window" of the first k of these bits, i. e. of the bits currently being examined to calculate the CRC, are therefore moved b bits forward.

Block 170a is followed by a block 180a in which a new parity check bit value relative to the new position of the k bits under examination is calculated by updating the block 160a calculation with the b new bits of the k new current bits determined in block 170a.

For example, block 180a sequentially enters the b new bits detected in block 170a into a shift register forming the parity check (defined previously) for the dummy vector.

New parity check bits are thus calculated for a new bit sequence (new vector) - also referred to as a new examination window - comprising, in sequence, the last k-b bits already examined of the received vector, and the next b bits.

Unlike the syndrome-based validation procedure, in which no distinction is made between the observation window and the examination window for which the control function is calculated, when validating by calculating the parity check bits, the examination window for calculating the control function only coincides with the first k bits of the observation window.

Finally, block 180a goes back to block 120a.

The advantages of the above method will be clear from the foregoing description. That is, as opposed to a new k-bit calculation, the operation in block 180a (parity check bit calculation) is performed by updating the block 160a calculation with b new bits.

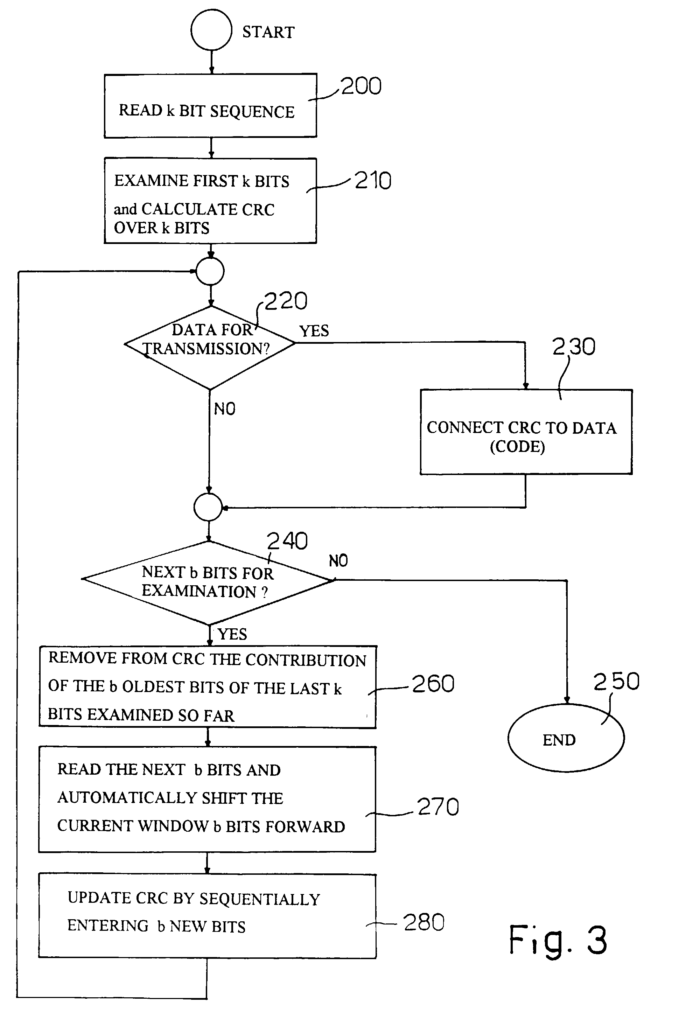

The steps in the coding of a cyclic code according to the method of the present invention will now be described with reference to Figure 3.

To begin with, a block 200 reads a sequence of k bits for coding.

Block 200 is followed by a block 210, which examines and applies a coding law to the k bits detected in block 200 to obtain a set of parity check bits (CRC calculation).

More details concerning the CRC calculation are to be found in "ERROR CORRECTING CODES" by Shu Lin and Daniel Costello, PRENTICE HALL Editions.

Block 210 is followed by a block 220, which determines whether a data transmission request is present. If it is, block 220 goes on to block 230. If it is not, block 220 goes on to block 240.

Block 230 provides for connecting the set of parity check bits calculated in block 210 to the k bits for transmission, and so forming an n-bit sequence defining a vector $r=(r_0, r_1, ......, r_{n-1})$ of length n, the first k bits of which are information bits, and the last n-k bits of which are the parity check bits calculated for block 210. Block 230 then goes on to block 240.

Block 240 determines whether a sufficient number of bits (e.g. b bits) have been detected to permit further coding. If they have not, block 240 goes on to block 250, which terminates the coding procedure. If they have, block 240 goes on to block 260.

Block 260 applies the coding law to a dummy vector $r_b$ of length k, the first b bits of which equal zero, and the next k-b bits of which equal the corresponding bits in the sequence. Coding is performed by "subtracting" from the current code a correction code calculated for a correction vector $r^{**}=(r_0, r_1, .. ., r_{b-1}, 0, ....., 0)$ of length k; which subtraction is made by performing a logic EXOR operation of each bit of the current code and the corresponding bit of the correction code.

Block 260 is followed by block 270, which reads b bits following the last bit used to calculate the parity check bits.

Block 270 is followed by block 280 in which the parity check bit calculation performed in block 260 for the dummy vector is updated with the b new bits to calculate a new set of parity check bits for a new bit sequence comprising, in sequence, the last k-b bits of the sequence and the next b new bits.

For example, block 280 sequentially enters the b new bits detected in block 270 into a shift register forming the code for the dummy vector.

Finally, block 280 goes back to block 220.

The advantages of the above method will be clear from the foregoing description. That is, as opposed to a new k-bit calculation, the operation in block 280 (parity check bit calculation) is performed by updating the block 260 calculation with b new bits.

For example, the method described may also be used for validating and/or coding codes substantially similar to cyclic codes, e.g. shortened cyclic codes.

## Claims

1. A validation method for the rapid validation of cyclic codes, comprising the following sequence of steps:

   a) acquiring (100) a sequence of n bits to be validated from an input stream; said sequence of n bits defining a received vector $r=(r_0, r_1, ...... r_{n-1})$ of length n;
   b) calculating (110) a current validation value (s) based on the n bits of the received vector r;
   c) using (120) the current validation value (s) to determine whether the received vector r is an acceptable codeword, characterized by comprising the steps of:
   d) calculating (160) a pseudo validation value ($s^p$) for a dummy vector rb of length n; the first b bits of the dummy vector being equal to zero, and the remaining n-b bits of the dummy vector being equal to the corresponding bits of the vector r, such that $r_b=(0, ..., 0, r_b, ...., r_{n-1})$, and b being smaller than n; said step of calculating (160) a pseudo validation value ($s^p$) comprising the steps of:

   - acquiring a correction validation value for a correction vector $r'=(r_0, r_1 ...., r_{b-1}, 0, ...., 0)$ of length n; the first b bits of the correction vector being equal to the corresponding bits of the received vector r, and the next n-b bits of the correction vector being equal to zero; and
   - subtracting said correction validation value from the current validation value (s) to calculate said pseudo validation value ($s^p$);

   the validation method further comprising the steps of:
   e) acquiring (170) b new bits from the input stream following the last acquired bits; and
   f) calculating (180) a new validation value from the pseudo validation value ($s^p$) and the b newly acquired bits, the new validation value forming the current validation value for the sequence of n bits comprising, in sequence, the last n-b bits from the previously acquired vector r and the b newly acquired bits, whereby the step of calculating the new validation value is performed by sequentially entering the b newly acquired bits into a shift register type divider forming said pseudo validation value.

2. A method as claimed in Claim 1, characterized in that said step of calculating said validation value (110) based on the n bits of the received vector r comprises the step of calculating the syndrome s.

3. A method as claimed in Claim 2, characterized in that said syndrome s is calculated by multiplying the received vector r by a transpose of a parity check matrix H ($s=rH^T$).

4. A method as claimed in Claim 2, characterized in that said step of calculating said syndrome s comprises the step of sequentially entering said received n bits into said shift register type divider.

5. A method as claimed in any one of the foregoing Claims from 2 to 4, characterized in that said step of using (120) the validation value (s) to determine whether the received vector r is an acceptable codeword comprises the step of determining whether the syndrome s equals a zero vector.

6. A method as claimed in any one of the foregoing Claims from 2 to 5, characterized in that said step of calculating (160) a pseudo validation value ($s^p$) comprises the step of calculating the syndrome of said dummy vector $r_b$.

7. A method as claimed in any one of the foregoing claims, characterized in that said step of subtracting said correction validation value from the current validation value (s) comprises the step of performing an EXOR operation of the current validation value (s) and said correction validation value.

8. A method as claimed in Claim 2, characterized in that said step of acquiring a correction validation value comprises the step of calculating a correction syndrome; said correction syndrome comprises a simplified form obtained by referring the entire syndrome calculation procedure to a cyclic rotation of said received vector; said simplified form of said correction syndrome, in the event b < n - k, where k is the number of information bits of said received vector r, comprising a sequence of bits comprising the first b bits ($r_0$, $r_1$ .... , $r_{b-1}$) of the received vector r, followed by n-k-b zero bits.

9. A method as claimed in Claim 2, characterized in that said step of acquiring a correction validation value comprises the step of calculating a correction syndrome; said step of calculating a correction syndrome for a correction vector r'= ($r_0$,$r_1$, .... ,$r_{b-1}$,0,....,0) of length n comprises the step of calculating the syndrome of a cyclic rotation of said correction vector.

10. A method as claimed in Claim 9, characterized in that said syndrome s is calculated by multiplying a cyclic rotation of the received vector r by a transpose of a parity check matrix H.

11. A validation method for the rapid validation of cyclic codes, comprising the following sequence of steps:

a) acquiring (100a) a sequence of n bits to be validated from an input stream; said sequence of n bits defining a received vector r=($r_0$, $r_1$, ...., $r_{n-1}$) of length n;

b) calculating (110a) a current validation value (CRC) based on at least the first k bits of the received vector r, whereby k is smaller or equal to n;

c) using (120a) the current validation value (CRC) to determine whether the received vector r is an acceptable codeword, characterized by comprising the steps of:

d) calculating (160a) a pseudo validation value ($CRC^p$) for a dummy vector rb of predetermined length k; the first b bits of the dummy vector being equal to zero, and the remaining k-b bits of the dummy vector being equal to the corresponding bits of the vector r, such that $r_b$= (0, ...., 0,$r_b$, ...., $r_{k-1}$), and b being smaller than k; said step of calculating (160a) a pseudo validation value ($CRC^p$) comprising the steps of:

- acquiring a correction validation value for a correction vector r**= ($r_0$,$r_1$, .... ,$r_{b-1}$/0, .... 0) of length k; the first b bits of the correction vector being equal to the corresponding bits of the received vector and the next k-b bits of the correction vector being equal to zero;
- subtracting said correction validation value from the current validation value to calculate said pseudo validation value ($CRC^p$);

the method further comprising the steps of:

e) reading (170a) b new bits from the input stream following the last n acquired bits to be validated thereby moving the position of the n bits to be validated, the vector r, and the first k bits of vector r, in points a) to d) above b bits forward in the input stream;

f) calculating (180a) a new validation value for the new position of the k bits under examination by updating the calculation of step d), whereby the calculation of the new validation value is performed by sequentially entering the b new bits of the k new current bits determined in step c) into a shift register type divider forming said pseudo validation value.

12. A validation method as claimed in Claim 11, characterized in that said step of calculating (l10a) a validation value comprises the steps of applying a parity check law to the first k bits of the received vector r to obtain a parity check (CRC); the parity check (CRC) refers to the k bits as to its information bits; said step of calculating a pseudo validation value ($CRC^p$) comprising the steps of:

- applying said parity check law (160a) to a dummy vector $r_b$ of length k; the first b bits of the dummy vector being equal to zero, and the next k-b bits of the dummy vector being equal to the corresponding bits of the previously acquired vector r;
- acquiring (170a) b new bits and examining b bits following the last bit used for calculating the current parity; and
- updating (180a) the parity check bit calculation with the b next bits examined, to calculate a new set of parity check bits for a new sequence of bits comprising, in sequence, the last k-b bits already examined and used in the preceding parity check bit calculation, and the b next bits examined.

13. A method as claimed in Claim 12, characterized in that said step of applying said parity check law (160a) to a dummy vector $(r_b)$ of length k comprises the step of subtracting from the current parity check a correction parity check calculated for a correction vector $r^{**}= (r_0, r_1, ...., r_{b-1}, 0,....,0)$ of length k; the first b bits of the correction vector being equal to the corresponding bits of the received vector r, and the next k-b bits of the correction vector being equal to zero.

14. A method as claimed in Claim 13, characterized in that said subtracting step comprises the step of performing a logic EXOR operation of the current parity check and said correction parity check.

15. A method as claimed in Claim 11, characterized in that said step of using (120a) the validation value (CRC) to determine whether the received vector is an acceptable codeword comprises the step of comparing said parity check with the parity check bits of the received vector.

16. A method as claimed in any one of the foregoing Claims, characterized in that said step of using the validation value (s; CRC) to determine whether the received vector (s) is an acceptable codeword is followed by the step of determining (140; 140a) whether a sufficient number (b) of bits is detected for performing further processing, and by the step of terminating (150; 150a) the data acquisition operations in the event an insufficient number of bits is detected.

17. A method for rapid coding of cyclic codes, comprising the steps of:

- acquiring (200) a sequence of k bits for coding;
- applying a coding law to said k bits to calculate (210) a current validation value, characterized by comprising the steps of:

- applying (260) said coding law to a dummy vector $(r_b)$ of length k to calculate a pseudo validation value; the first b bits of the dummy vector being equal to zero, and the next k-b bits of the dummy vector being equal to the corresponding bits in the sequence;
- acquiring (270) b new bits following the last bit used for calculating the current validation value; and
- updating the validation value calculation previously performed (260) by sequentially entering, into a shift register type divider forming the pseudo validation value, the b newly acquired bits to calculate a new validation value for a new sequence of bits comprising, in sequence, the last k-b bits of the sequence and the next b new bits;
- said method further comprising the steps of acquiring a correction validation value calculated for a correction vector $r^{**}= (r_0, r_1 ...., r_{b-1}, 0, ...., 0)$ of length k; the first b bits of the correction vector being equal to the corresponding bits in the sequence, and the next k-b bits of the correction vector being equal to zero;
- said step of applying (260) said coding law to a dummy vector (rb) comprises the step of subtracting from the current validation value the correction validation value.

18. A method as claimed in Claim 17, characterized in that said subtracting step comprises the step of performing a logic EXOR operation of the current validation value and said correction validation value.

19. A method as claimed in any one of the foregoing Claims, characterized in that said cyclic codes are shortened cyclic codes.

20. A method as claimed in any one of the foregoing claims, characterised by the fact that said step of acquiring a correction validation value comprises the step of searching among pre calculated values of said correction validation value.

**Patentansprüche**

1. Datenüberprüfungsverfahren zur schnellen Datenüberprüfung von zyklischen Kodes, mit der folgenden Sequenz von Schritten:

a) Erwerben (100) einer Sequenz von n Bits, die auf Zulässigkeit zu überprüfen sind, aus einem Eingangsstrom; wobei die Sequenz der n Bits einen empfangen Vektor $r=(r_0, r_1,...... r_{n-1})$ der Länge n definiert;
b) Berechnen (110) eines laufenden oder momentanen Zulässigkeitswertes (s) basierend auf den n Bits des empfangenen Vektors;

c) Verwenden (120) des momentanen oder laufenden Zulässigkeitswertes (s) zum Bestimmen, ob der empfangene Vektor r ein annehmbares Kodewort ist,

gekennzeichnet durch die folgenden Schritte:

d) Berechnen (160) eines Pseudo-Zulässigkeitswertes ($s^p$) für einen Leervektor (dummy vector) der Länge n; wobei die ersten b Bits des Leervektors gleich Null sind und die verbleibenden n-b Bits des Leervektors gleich sind den entsprechenden Bits des Vektors r, derart, daß $r_b=(0, ...., 0, r_b, ...., r_{n-1})$ und b kleiner ist als n; wobei der Schritt der Berechnung (160) eines Pseudo-Zulässigkeitswertes ($s^p$) die folgenden Schritte umfaßt:

- Erwerben eines Korrektur-Zulässigkeitswertes für einen Korrekturvektor $r'(r_0,r_1,...., r_{b-1}, 0, ....,0)$ der Länge n; wobei die ersten b Bits des Korrekturvektors gleich sind den entsprechenden Bits des empfangenen Vektors r und wobei die nächsten n-b Bits des Korrekturvektors gleich sind Null; und
- Subtrahieren des Korrektur-Zulässigkeitswertes von dem momentanen Zulässigkeitswert (s), um den Pseudo-Zulässigkeitswert ($s^p$) zu berechnen;

wobei das Datenüberprüfungsverfahren ferner die folgenden Schritte umfaßt:

e) Erwerben (170) von b neuen Bits für den Eingangsstrom nachfolgend den letzten erworbenen Bits; und

f) Berechnen (180) eines neuen Zulässigkeitswertes aus dem Pseudo-Zulässigkeitswert ($s^p$) und den neu erworbenen b Bits, wobei der neue Zulässigkeitswert, der den momentanen Zulässigkeitswert für die Sequenz der n Bits bildet, in Aufeinanderfolge die letzten n-b Bits von dem an früherer Stelle erworbenen Vektor r und die b neu erworbenen Bits umfaßt, wodurch der Schritt der Berechnung des neuen Zulässigkeitswertes dadurch ausgeführt wird, indem sequentiell die b neu erworbenen Bits in ein Schieberegister vom Typ eines Teilers eingespeist werden, welches den Pseudo-Zulässigkeitswert bildet.

2. Verfahren nach Anspruch 1, dadurch **gekennzeichnet,** daß der Schritt der Berechnung des Zulässigkeitswertes (110) basierend auf den n Bits des empfangenen Vektors r den Schritt der Berechnung des Syndroms s umfaßt.

3. Verfahren nach Anspruch 2,

dadurch **gekennzeichnet,** daß das Syndrom s dadurch berechnet wird, indem der empfangene Vektor r mit einer Transponierung einer Paritätsprüfmatrix H multipliziert wird ($s=rH^T$).

4. Verfahren nach Anspruch 2, dadurch **gekennzeichnet,** daß der Schritt der Berechnung des Syndroms s den Schritt eines sequentiellen Einspeisens der empfangenen n Bits in das Schieberegister vom Typ eines Teilers umfaßt.

5. Verfahren nach irgendeinem der vorhergehenden Ansprüche 2 bis 4, dadurch **gekennzeichnet,** daß der Schritt der Verwendung (120) des Zulässigkeitswertes (s), um zu bestimmen, ob der empfangene Vektor r ein annehmbares Kodewort ist, den Schritt umfaßt, gemäß einem Bestimmung, ob das Syndrom s gleich ist einem Null-Vektor.

6. Verfahren nach irgendeinem der vorhergehenden Ansprüche 2 bis 5, dadurch **gekennzeichnet,** daß der Schritt der Berechnung (160) eines Pseudo-Zulässigkeitswertes ($s^p$) den Schritt der Berechnung des Syndroms des Leervektors $r_b$ umfaßt.

7. Verfahren nach irgendeinem der vorhergehenden Ansprüche, dadurch **gekennzeichnet,** daß der Schritt gemäß dem Subtrahieren des Korrektur-Zulässigkeitswertes von dem momentanen Zulässigkeitswert (s) den Schritt gemäß der Ausführung einer EXKLUSIV-ODER-Operation des momentanen Zulässigkeitswertes (s) und des Korrektur-Zulässigkeitswertes umfaßt.

8. Verfahren nach Anspruch 2, dadurch **gekennzeichnet,** daß der Schritt gemäß dem Erwerben eines Korrektur-Zulässigkeitswertes den Schritt der Berechnung eines Korrektursyndroms umfaßt; wobei das Korrektursyndrom eine vereinfachte Form aufweist, die durch Überführen der gesamten Syndromberechnungsprozedur auf eine zyklische Drehung des empfangenen Vektors erhalten wird; wobei die vereinfachte Form des Korrektursyndroms für den Fall b < n - k, worin k die Zahl der Informationsbits des empfangenen Vektors r ist, eine Sequenz von Bits umfaßt, die die ersten b Bits $(r_0, r_1, ...., r_{b-1})$ des empfangenen Vektors r, gefolgt durch n-k-b Null-Bits umfaßt.

9. Verfahren nach Anspruch 2, dadurch **gekennzeichnet,** daß der Schritt des Erwerbens eines Korrektur-Zulässigkeitswertes den Schritt der Berechnung eines Korrektursyndroms umfaßt; wobei der Schritt der Berechnung eines Korrektursyndroms für einen Korrekturvektor r'= ($r_0$,

$r_1$, ...., $r_{b-1}$, 0, ...., 0) der Länge n den Schritt gemäß einem Berechnen des Syndroms einer zyklischen Drehung des Korrekturvektors umfaßt.

10. Verfahren nach Anspruch 9,
dadurch **gekennzeichnet,** daß das Syndrom s dadurch berechnet wird, indem eine zyklische Drehung des empfangenen Vektors r mit einer Transponierung einer Paritätsprüfmatrix H multipliziert wird.

11. Datenüberprüfungsverfahren zur schnellen Zulässigkeitsprüfung von zyklischen Kodes, mit der folgenden Sequenz von Schritten:

   a) Erwerben (100a) einer Sequenz von n Bits, die auf Zulässigkeit zu überprüfen sind, aus einem Eingangsstrom; wobei die Sequenz der n Bits einen empfangen Vektor r= ($r_0$, $r_1$, ...., $r_{n-1}$) der Länge n definiert;
   b) Berechnen (110a) eines laufenden oder momentanen Zulässigkeitswertes (CRC) basierend auf wenigstens den ersten k Bits des empfangenen Vektors r, worin k kleiner ist als oder gleich ist mit n;
   c) Verwenden (120a) des momentanen oder gegenwärtigen Zulässigkeitswertes (CRC) zum Bestimmen, ob der empfangene Vektor r ein annehmbares Kodewort ist, gekennzeichnet durch die folgenden Schritte:
   d) Berechnen (160a) eines Pseudo-Zulässigkeitswertes (CRCᵖ) für einen Leervektor $r_b$ der vorbestimmten Länge k; wobei die ersten b Bits des Leervektors gleich Null sind und wobei die verbleibenden k-b Bits des Leervektors gleich sind den entsprechenden Bits des Vektors r, derart, daß $r_b$ = (0, ...., 0, $r_b$, ...., $r_{k-1}$) und b kleiner ist als k; wobei der Schritt der Berechnung (160a) eines Pseudo-Zulässigkeitswertes (CRCᵖ) die folgenden Schritte umfaßt:

   - Erwerben eines Korrektur-Zulässigkeitswertes für einen Korrekturvektor r**= ($r_0$, $r_1$, ...., $r_{b-1}$, 0, ...., 0) der Länge k; wobei die ersten b Bits des Korrekturvektors gleich sind den entsprechenden Bits des empfangenen Vektors und die nächsten k-b Bits des Korrekturvektors gleich sind Null;
   - Subtrahieren des Korrektur-Zulässigkeitswertes von dem momentanen Zulässigkeitswert, um den Pseudo-Zulässigkeitswert (CRCᵖ) zu berechnen;

   wobei das Verfahren noch die weiteren folgenden Schritte umfaßt:
   e) Lesen (170a) von b neuen Bits aus dem Eingangsstrom nachfolgend den letzten n erworbenen Bits, die auf Zulässigkeit zu überprüfen sind, um dadurch die Position der n Bits, die auf Zulässigkeit zu überprüfen sind, den Vektor r und die ersten k Bits des Vektors r an den Stellen a) bis d) über den b Bits nach vorne in dem Eingangsstrom zu bewegen;
   f) Berechnen (180a) eines neuen Zulässigkeitswertes für die neue Position der k Bits, die unter der Prüfung stehen, indem die Berechnung bei dem Schritt d) auf den neuesten Stand gebracht wird, wodurch die Berechnung des neuen Zulässigkeitswertes dadurch ausgeführt wird, indem sequenziell die b neuen Bits der k neuen momentanen Bits, die in dem Schritt c) bestimmt wurden, in ein Schieberegister vom Typ eines Teilers eingespeist werden, welches den Pseudo-Zulässigkeitswert formt.

12. Datenüberprüfungsverfahren nach Anspruch 11,
dadurch **gekennzeichnet,** daß der Schritt der Berechnung (110a) eines Zulässigkeitswertes die Schritte umfaßt, gemäß Anwenden eines Paritätsprüfgesetzes auf die ersten k Bits des empfangenen Vektors r, um eine Partitätsprüfung (CRC) zu erhalten; wobei die Paritätsprüfgröße (CRC) auf die k Bits als deren Informationsbits verweist; wobei der Schritt der Berechnung eines Pseudo-Zulässigkeitswertes (CRCᵖ) die folgenden Schritte umfaßt:

   - Anwenden des Paritätsprüfgesetzes (160a) auf einen Leervektor ($r_b$) der Länge k; wobei die ersten b Bits des Leervektors gleich sind mit Null und wobei die nächsten k-b Bits des Leervektors gleich sind den entsprechenden Bits des an früherer Stelle erworbenen Vektors r;
   - Erwerben (170a) von b neuen Bits und Prüfen der b Bits, die auf das letzte Bit folgen, welches zum Berechnen der laufenden oder momentanen Parität verwendet wurde; und
   - Erneuern (180a) der Paritätsprüfbitberechnung mit dem b nächsten geprüften Bit, um einen neuen Satz von Paritätsprüfbits für eine neue Sequenz von Bits zu berechnen, die in einer Aufeinanderfolge die letzten k-b Bits, die bereits geprüft wurden, umfassen und die bei der vorhergehenden Paritätsprüfbitberechnung verwendet wurden und die b geprüften nächsten Bits umfaßt.

13. Verfahren nach Anspruch 12,
dadurch **gekennzeichnet,** daß der Schritt der Anwendung des Paritätsprüfgesetzes (160a) bei einem Leervektor ($r_b$) der Länge k den Schritt umfaßt, gemäß einem Subtrahieren einer Korrekturparitätsprüfgröße von der momentanen Paritätsprüfgröße, wobei die Korrekturparitätsprüfgröße für einen Korrekturvektor r** = ($r_0$, $r_1$, ...., $r_{b-1}$, 0, ...., 0) der Länge k berechnet wurde; wobei die ersten b Bits des Korrekturvektors gleich sind den entsprechenden Bits des empfangenen Vektors r und die nächsten k-b Bits des Korrekturvektors gleich sind Null.

14. Verfahren nach Anspruch 13, dadurch **gekennzeichnet,** daß der Subtrahierschritt den Schritt der Ausführung einer logischen EXKLUSIV-ODER-Operation der laufenden Paritätsprüfgröße und der Korrekturparitätsprüfgröße umfaßt.

15. Verfahren nach Anspruch 11, dadurch gekennzeichnet, daß der Schritt der Verwendung (120a) des Zulässigkeitswertes (CRC), um zu bestimmen, ob der empfangene Vektor ein annehmbares Kodewort ist, den Schritt gemäß einem Vergleichen der Paritätsprüfgröße mit den Paritätsprüfbits des empfangenen Vektors umfaßt.

16. Verfahren nach irgendeinem der vorhergehenden Ansprüche, dadurch **gekennzeichnet,** daß der Schritt der Verwendung des Zulässigkeitswertes (s; CRC), um zu bestimmen, ob der empfangene Vektor (s) ein annehmbares Kodewort ist, gefolgt wird von dem Schritt der Bestimmung (140; 140a), ob eine ausreichende Zahl (b) der Bits detektiert wurde, um eine weitere Verarbeitung durchzuführen, und von einem Schritt der Beendigung (150; 150a) der Datengewinnungsoperationen für den Fall, daß eine unzureichende Anzahl von Bits detektiert wird, gefolgt wird.

17. Verfahren zur schnellen Kodierung von zyklischen Kodes, mit den folgenden Schritten:

- Erwerben (200) einer Sequenz von k Bits für einen Kodierungsvorgang;
- Anwenden eines Kodierungsgesetzes auf die k Bits, um einen momentanen Gültigkeitswert zu berechnen (210), **gekennzeichnet** durch die folgenden Schritte:

  - Anwenden (260) des Kodierungsgesetzes auf einen Leervektor ($r_b$) der Länge k, um einen Pseudo-Zulässigkeitswert zu berechnen; wobei die ersten b Bits des Leervektors gleich sind Null und die nächsten k-b Bits des Leervektors gleich sind den entsprechenden Bits in der Sequenz;
  - Erwerben (270) von b neuen Bits, die auf das letzte Bit folgen, welches zur Berechnung des laufenden oder momentanen Zulässigkeitswertes verwendet wurde; und
  - Erneuern der Zulässigkeitswertberechnung, die an früherer Stelle durchgeführt wurde (260), indem sequentiell in ein Schieberegister vom Teilertyp, welches den Pseudo-Zulässigkeitswert herstellt, die b neu erworbenen Bits eingespeist werden, um einen neuen Zulässigkeitswert für eine neue Sequenz der Bits zu berechnen, die in einer Aufeinanderfolge die letzten k-b Bits der Sequenz und die nächsten b neuen Bits enthält;

- das Verfahren ferner die Schritte umfaßt, gemäß einem Erwerben eines Korrektur-Zulässigkeitswertes, der für einen Korrekturvektor $r^{**} = (r_0, r_1, ...., r_{b-1}, 0,....,0)$ der Länge k berechnet wurde; wobei die ersten b Bits des Korrekturvektors gleich sind den entsprechenden Bits in der Sequenz und die nächsten k-b Bits des Korrekturvektors gleich sind Null;

- wobei der Schritt der Anwendung (260) des Kodierungsgesetzes auf einen Leervektor ($r_b$) den Schritt gemäß einem Subtrahieren des Korrektur-Zulässigkeitswertes von dem momentanen oder laufenden Zulässigkeitswert umfaßt.

18. Verfahren nach Anspruch 17, dadurch **gekennzeichnet,** daß der Subtrahierschritt den Schritt der Durchführung einer logischen EXKLUSIV-ODER-Operation des laufenden oder momentanen Zulässigkeitswertes und des Korrektur-Zulässigkeitswertes umfaßt.

19. Verfahren nach irgendeinem der vorhergehenden Ansprüche, dadurch **gekennzeichnet,** daß die zyklischen Kodes aus verkürzten zyklischen Kodes bestehen.

20. Verfahren nach irgendeinem der vorhergehenden Ansprüche, **gekennzeichnet** durch die Tatsache, daß der Schritt des Erwerbens eines Korrektur-Zulässigkeitswertes den Schritt des Suchens unter im voraus berechneten Werten des Korrektur-Zulässigkeitswertes umfaßt.

## Revendications

1. Procédé de validation pour la validation rapide de codes cycliques, comprenant la séquence d'étapes suivante :

   a) acquisition (100) d'une séquence de n bits à valider à partir d'un courant d'entrée ; ladite séquence de n bits définissant un vecteur reçu r= $(r_0, r_1, ......, r_{n-1})$ de longueur n ;
   b) calcul (110) d'une valeur de validation courante (s) basée sur les n bits du vecteur reçu r ;
   c) utilisation (120) de la valeur de validation courante (s) pour déterminer si le vecteur reçu r est un mot de code acceptable, caractérisé par le fait qu'il comprend les étapes consistant à :

d) calculer (160) une valeur de pseudo validation ($s^p$) pour un vecteur fictif $r_b$ de longueur n ; les b premiers bits du vecteur fictif étant égaux à zéro et les n-b bits restants du vecteur fictif étant égaux aux bits correspondants du vecteur r, de façon que $r_b = (0, ...., 0, r_b, ......., r_{n-1})$ et b étant plus petit que n ; ladite étape de calcul (160) d'une valeur de pseudo validation ($s^p$) comprenant les étapes consistant à :

- acquérir une valeur de validation de correction pour un vecteur de correction r' = $(r_0, r_1, ......., r_{b-1}, 0, ...., 0)$ de longueur n ; les b premiers bits du vecteur de correction étant égaux aux bits correspondants du vecteur reçu r et les n-b bits suivants du vecteur de correction étant égaux à zéro ; et
- soustraire ladite valeur de validation de correction de la valeur de validation courante (s) pour calculer ladite valeur de pseudo validation ($s^p$) ;

le procédé de validation comprenant en outre les étapes consistant à :

e) acquérir (170) b nouveaux bits à partir du courant d'entrée, qui suivent les derniers bits acquis ; et

f) calculer (180) une nouvelle valeur de validation d'après la valeur de pseudo validation ($s^p$) et les b bits nouvellement acquis, la nouvelle valeur de validation constituant la valeur de validation courante pour la séquence de n bits comprenant, en séquence, les n-b derniers bits du vecteur précédemment acquis r et les b bits nouvellement acquis, de façon que l'étape de calcul de la nouvelle valeur de validation soit exécutée en entrant séquentiellement les b bits nouvellement acquis dans un diviseur du type à registre à décalage formant ladite valeur de pseudo validation.

2. Procédé selon la revendication 1, caractérisé en ce que ladite étape de calcul de ladite valeur de validation (110) basée sur les n bits du vecteur reçu r comprend l'étape de calcul du syndrome s.

3. Procédé selon la revendication 2, caractérisé en ce que ledit syndrome s est calculé en multipliant le vecteur reçu r par la transposée d'une matrice de contrôle de parité H ($s=rH^T$).

4. Procédé selon la revendication 2, caractérisé en ce que ladite étape de calcul dudit syndrome s comprend l'étape consistant à entrer séquentiellement lesdits n bits reçus dans ledit diviseur du type à registre à décalage.

5. Procédé selon l'une quelconque des revendications 2 à 4 précédentes, caractérisé en ce que ladite étape d'utilisation (120) de la valeur de validation (s) pour déterminer si le vecteur reçu r est un mot de code acceptable comprend l'étape de détermination du fait que le syndrome s est égal à un vecteur à zéro.

6. Procédé selon l'une quelconque des revendications 2 à 5 précédentes, caractérisé en ce que ladite étape de calcul (160) d'une valeur de pseudo validation ($s^p$) comprend l'étape de calcul du syndrome dudit vecteur fictif $r_b$.

7. Procédé selon l'une quelconque des revendications précédentes, caractérisé en ce que ladite étape de soustraction de ladite valeur de validation de correction de la valeur de validation courante (s) comprend l'étape d'exécution d'une opération OU EXCLUSIF de la valeur de validation courante (s) et de ladite valeur de validation de correction.

8. Procédé selon la revendication 2, caractérisé en ce que ladite étape d'acquisition d'une valeur de validation de correction comprend l'étape de calcul d'un syndrome de correction ; ledit syndrome de correction comprend une forme simplifiée obtenue par référence de l'ensemble de la procédure de calcul de syndrome à une rotation cyclique dudit vecteur reçu ; ladite forme simplifiée dudit syndrome de correction, dans le cas où b < n - k, k étant le nombre de bits d'informations dudit vecteur reçu r, comprenant une séquence de bits comprenant les b premiers bits $(r_0, r_1, ......., r_{b-1})$ du vecteur reçu r, suivis par n-k-b bits à zéro.

9. Procédé selon la revendication 2, caractérisé en ce que ladite étape d'acquisition d'une valeur de validation de correction comprend l'étape de calcul d'un syndrome de correction ; ladite étape de calcul d'un syndrome de correction pour un vecteur de correction r' = $(r_0, r_1, ......., r_{b-1}, 0, ...., 0)$ de longueur n comprend l'étape de calcul du syndrome de rotation cyclique dudit vecteur de correction.

10. Procédé selon la revendication 9, caractérisé en ce que ledit syndrome s est calculé par multiplication d'une rotation cyclique du vecteur reçu r par une transposée de la matrice de contrôle de parité H.

11. Procédé de validation pour la validation rapide de codes cycliques, comprenant la séquence d'étapes suivante :

a) acquisition (100a) d'une séquence de n bits à valider à partir d'un courant d'entrée ; ladite séquence de n bits définissant un vecteur reçu $r = (r_0, r_1, ......., r_{n-1})$ de longueur n ;

b) calcul (110a) d'une valeur de validation courante (CRC) basée sur au moins les k premiers bits du vecteur reçu r, telle que k est inférieur ou égal à n ;

c) utilisation (120a) de la valeur de validation courante (CRC) pour déterminer si le vecteur reçu r est un mot de code acceptable, caractérisé par le fait qu'il comprend les étapes consistant à :

d) calculer (160a) une valeur de pseudo validation (CRC$^p$) pour un vecteur fictif $r_b$ de longueur prédéterminée k ; les b premiers bits du vecteur fictif étant égaux à zéro et les k-b bits restants du vecteur fictif étant égaux aux bits correspondants du vecteur r, de façon que $r_b = (0, ...., 0, r_b, ......., r_{k-1})$ et b étant plus petit que k ; ladite étape de calcul (160a) d'une valeur de pseudo validation (CRC$^p$) comprenant les étapes consistant à :

- acquérir une valeur de validation de correction pour un vecteur de correction $r^{**} = (r_0, r_1, ......, r_{b-1}, 0, ...., 0)$ de longueur k ; les b premiers bits du vecteur de correction étant égaux aux bits correspondants du vecteur reçu et les k-b bits suivants du vecteur de correction étant égaux à zéro ;
- soustraire ladite valeur de validation de correction de la valeur de validation courante pour calculer ladite valeur de pseudo validation (CRC$^p$) ;

le procédé comprenant en outre les étapes consistant à :

e) lire (170a) b nouveaux bits à partir du courant d'entrée qui suivent les n derniers bits acquis à valider de façon à déplacer la position des n bits à valider, le vecteur r et les k premiers bits du vecteur r, dans les points a) à d) au-dessus de b bits vers l'avant dans le courant d'entrée ;

f) calculer (180a) une nouvelle valeur de validation une nouvelle valeur de validation pour la nouvelle position des k bits en cours d'examen en mettant à jour le calcul de l'étape d), de façon que le calcul de la nouvelle valeur de validation soit exécuté en entrant séquentiellement les b nouveaux bits des k nouveaux bits courants déterminés à l'étape c) dans un diviseur du type à registre à décalage formant ladite valeur de pseudo validation.

12. Procédé de validation selon la revendication 11, caractérisé en ce que ladite étape de calcul (110a) d'une valeur de validation comprend les étapes consistant à appliquer une loi de contrôle de parité aux k premiers bits du vecteur reçu r pour obtenir un contrôle de parité (CRC) ; le contrôle de parité (CRC) faisant référence aux k bits pour ses bits d'informations ; ladite étape de calcul d'une valeur de pseudo validation (CRC$^p$) comprenant les étapes consistant à :

- appliquer ladite loi de contrôle de parité (160a) à un vecteur fictif $r_b$ de longueur k ; les b premiers bits du vecteur fictif étant égaux à zéro et les k-b bits suivants du vecteur fictif étant égaux aux bits correspondants du vecteur précédemment acquis r ;
- acquérir (170a) b nouveaux bits et examiner b bits qui suivent le dernier bit utilisé pour calculer la parité courante ; et
- mettre à jour (180a) le calcul de bits de contrôle de parité avec les b bits suivants examinés, pour calculer un nouvel ensemble de bits de contrôle de parité pour une nouvelle séquence de bits comprenant, en séquence, les k-b derniers bits déjà examinés et utilisés dans le calcul de bits de contrôle de parité précédent et les b bits suivants examinés.

13. Procédé selon la revendication 12, caractérisé en ce que ladite étape d'application de ladite loi de contrôle de parité (160a) à un vecteur fictif ($r_b$) de longueur k comprend l'étape de soustraction du contrôle de parité courant d'un contrôle de parité de correction calculé pour un vecteur de correction $r^{**} = (r_0, r_1, ......., r_{b-1}, 0, ...., 0)$ de longueur k ; les b premiers bits du vecteur de correction étant égaux aux bits correspondants du vecteur reçu r et les k-b bits suivants du vecteur de correction étant égaux à zéro.

14. Procédé selon la revendication 13, caractérisé en ce que ladite étape de soustraction comprend l'étape d'exécution d'une opération logique OU EXCLUSIF du contrôle de parité courant et dudit contrôle de parité de correction.

15. Procédé selon la revendication 11, caractérisé en ce que ladite étape d'utilisation (120a) de la valeur de validation (CRC) pour déterminer si le vecteur reçu est un mot de code acceptable comprend l'étape de comparaison dudit contrôle de parité avec les bits de contrôle de parité du vecteur reçu.

16. Procédé selon l'une quelconque des revendications précédentes, caractérisé en ce que ladite étape d'utilisation de la valeur de validation (s ; CRC) pour déterminer si le vecteur reçu (s) est un mot de code acceptable est suivie par l'étape de détermination (140 ; 140a) du fait qu'un nombre suffisant (b) de bits est détecté pour exécuter un autre traitement et par l'étape de fin (150 ; 150a) des opérations d'acquisition de données dans le cas où un nombre insuffisant de bits est détecté.

**17.** Procédé de codage rapide de codes cycliques, comprenant les étapes consistant à :

- acquérir (200) une séquence de k bits pour codage ;
- appliquer une loi de codage auxdits k bits pour calculer (210) une valeur de validation courante, caractérisé par le fait qu'il comprend les étapes consistant à :

  - appliquer (260) ladite loi de codage à un vecteur fictif ($r_b$) de longueur k pour calculer une valeur de pseudo validation ; les b premiers bits du vecteur fictif étant égaux à zéro et les k-b bits suivants du vecteur fictif étant égaux aux bits correspondants dans la séquence ;
  - acquérir (270) b nouveaux bits qui suivent le dernier bit utilisé pour calculer la valeur de validation courante ; et
  - mettre à jour le calcul de valeur de validation précédemment exécuté (260) en entrant séquentiellement, dans un diviseur du type à registre à décalage formant la valeur de pseudo validation, les b bits nouvellement acquis pour calculer une nouvelle valeur de validation pour une nouvelle séquence de bits comprenant, en séquence, les k-b derniers bits de la séquence et les b nouveaux bits suivants ;
  - ledit procédé comprenant en outre les étapes consistant à acquérir une valeur de validation de correction calculée pour un vecteur de correction $r^{**} = (r_0, r_1, ......., r_{b-1}, 0, ...., 0)$ de longueur k ; les b premiers bits du vecteur de correction étant égaux aux bits correspondants dans la séquence et les k-b bits suivants du vecteur de correction étant égaux à zéro ;
  - ladite étape d'application (260) de ladite loi de codage à un vecteur fictif ($r_b$) comprend l'étape consistant à soustraire de la valeur de validation courante la valeur de validation de correction.

**18.** Procédé selon la revendication 17, caractérisé en ce que ladite étape de soustraction comprend l'étape d'exécution d'une opération logique OU EXCLUSIF de la valeur de validation courante et de ladite valeur de validation de correction.

**19.** Procédé selon l'une quelconque des revendications précédentes, caractérisé en ce que lesdits codes cycliques sont des codes cycliques raccourcis.

**20.** Procédé selon l'une quelconque des revendications précédentes, caractérisé par le fait que ladite étape d'acquisition d'une valeur de validation de correction comprend l'étape de recherche parmi les valeurs calculées à l'avance de ladite valeur de validation de correction.

START

READ
n BITS — 100

CALCULATE SYNDROME
s OF FIRST n BITS — 110

SYNDROME = 0 ? — 120

YES

NO

CURRENT n BITS NOT
A VALID TELEGRAM — 125

CURRENT n BITS A
VALID TELEGRAM — 130

NEXT b BITS
RECEIVED ? — 140

NO

YES

REMOVE FROM THE SYNDROME THE
CONTRIBUTION OF THE b OLDEST BITS
OF THE LAST n BITS EXAMINED SO FAR — 160

END — 150

READ THE NEXT b BITS AND
AUTOMATICALLY SHIFT THE
CURRENT WINDOW b BITS FORWARD — 170

UPDATE SYNDROME BY SEQUENTIALLY
ENTERING b NEW BITS — 180

Fig. 1

14

START

READ
n BITS — 100a

EXAMINE FIRST k BITS
CALCULATE CRC
OVER k BITS — 110a

120a
PARITY
CHECK OK ? → YES

NO

125a
CURRENT n BITS NOT
A VALID TELEGRAM

130a
CURRENT n BITS A
VALID TELEGRAM

140a
NEXT b BITS
RECEIVED ? → NO

YES

160a
REMOVE FROM CRC THE CONTRIBUTION
OF THE b OLDEST BITS OF THE LAST k
BITS EXAMINED SO FAR

150a
END

READ THE NEXT b BITS AND
AUTOMATICALLY SHIFT THE
CURRENT k-BIT and n-BIT WINDOWS
b BITS FORWARD — 170a

UPDATE CRC BY SEQUENTIALLY
ENTERING b NEW BITS OF k-BIT WINDOW — 180a

Fig. 2

START

READ k BIT SEQUENCE — 200

EXAMINE FIRST k BITS and CALCULATE CRC OVER k BITS — 210

220
DATA FOR TRANSMISSION?

YES

230
CONNECT CRC TO DATA (CODE)

NO

240
NEXT b BITS FOR EXAMINATION ?

NO

YES

REMOVE FROM CRC THE CONTRIBUTION OF THE b OLDEST BITS OF THE LAST k BITS EXAMINED SO FAR — 260

250
END

READ THE NEXT b BITS AND AUTOMATICALLY SHIFT THE CURRENT WINDOW b BITS FORWARD — 270

UPDATE CRC BY SEQUENTIALLY ENTERING b NEW BITS — 280

Fig. 3